# EUROPEAN PATENT APPLICATION

(11) **EP 3 355 472 A1**
(43) Date of publication of application: **01.08.2018**
(21) Application number: 17153075.1
(22) Date of filing: 25.01.2017
(51) Int. Cl.: H03F 1/56, H03F 3/24, H03F 3/72, H04B 1/58

(54) **INTEGRATED CIRCUIT FOR A TRANSCEIVER**

(71) Applicant: IMEC vzw, 3001 Leuven (BE)
(72) Inventor: KHALAF, Khaled, 3001 Leuven (BE); VAESEN, Kristof, 3001 Leuven (BE); WAMBACQ, Pierre, 3001 Leuven (BE)
(74) Representative: AWA Sweden AB

(57) **Abstract**

An integrated circuit for a transceiver comprises: a power amplifier, PA, output stage (120) comprising a first transistor (122) and a second transistor (124); a low noise amplifier, LNA, input stage (126) comprising a third transistor (128) and a fourth transistor (130); a differential impedance matching circuitry (108) configured to be connected to an antenna (102), wherein the differential impedance matching circuitry (108) comprises a first node (112) on one side and a second node (114) on an opposite side, wherein the first and third transistors (122; 128) are connected to the first node (112) and the second and fourth transistors (124; 130) are connected to the second node (114); wherein the differential impedance matching circuitry (108) comprises a third node (116) arranged between the first and second nodes (112; 114) and arranged to selectively receive a first or a second voltage.

## Description

### Technical Field

The present invention relates to an integrated circuit for a transceiver and to a method for switching between transmit mode and receive mode in an integrated circuit.

### Background

In time division duplex (TDD) systems, a transmitter circuitry and a receiver circuitry may share antenna. The antenna is switched between acting in transmit mode and in receive mode. The transmitter circuitry typically comprises a power amplifier (PA) for amplifying a signal to be transmitted. The receiver circuitry typically comprises a low noise amplifier (LNA) for amplifying a low-power signal.

The receiver circuitry needs to be isolated from the transmitter circuitry, as the LNA may load the PA when the transceiver is transmitting, degrading performance (output power) of the transceiver, and the PA may load the LNA when the transceiver is receiving, degrading performance (reflection coefficient, noise factor, gain) of the transceiver. Isolation of the transmitter circuitry and the receiver circuitry from each other may be achieved by having explicit radio-frequency switches at the output of the PA and at the input of the LNA. In the respective mode of the TDD system, the transmitter circuitry or the receiver circuitry may thus be switched off.

Since the transmitter circuitry and the receiver circuitry share the same antenna, an impedance matching circuitry may also be beneficially shared for matching the transmitter circuitry and the receiver circuitry, respectively, to the antenna. This may be combined with transistor switches, which may be operated by gate biases for switching on/off the transmitter circuitry and the receiver circuitry, respectively. With this configuration, impedances of the PA output of the transmitter circuitry and the LNA input of the receiver circuitry should be close to each other as the same matching circuitry is used.

The impedance matching sets requirements on the LNA design. Thus, it would be desired to provide an integrated circuit for a transceiver so as to enable more freely designing the LNA input of the receiver circuitry.

In Xiao et al, "A 65nm CMOS wideband TDD front-end with integrated T/R switching via PA re-use", 42nd European Solid-State Circuits Conference, 2016, a wideband time-division duplex (TDD) front-end with an integrated transmit/receive (T/R) switching technique is implemented in 65nm CMOS. By re-using the PA as an LNA during receive mode, the system eliminates the conventional series T/R switch from the signal path and utilizes only DC mode control switches to enable TDD co-existence. However, the system is quite complex since the PA is re-used as an LNA in receive mode. The re-use of the PA as an LNA also puts constraints on design of the LNA. Further, the splitting of transmitter circuitry and the recevier circuitry is shifted to a later stage of the respective circuitry, which may need to include a separate switch.

### Summary of the Invention

An objective of the present inventive concept is to provide an improved integrated circuit for a transceiver. It is a particular objective of the present inventive concept to provide an integrated circuit having a good isolation between a receiver circuitry and a transmitter circuitry while having low constraints on LNA design allowing good performance of the transceiver.

These and other objectives of the present inventive concept are at least partially met by the invention as defined in the independent claims. Preferred embodiments are set out in the dependent claims.

According to a first aspect, there is provided an integrated circuit for a transceiver, said integrated circuit comprising: a power amplifier (PA) output stage comprising a first transistor and a second transistor; a low noise amplifier (LNA) input stage comprising a third transistor and a fourth transistor; a differential impedance matching circuitry configured to be connected to an antenna, wherein the differential impedance matching circuitry comprises a first node on one side of the differential impedance matching circuitry and a second node on an opposite side of the differential impedance matching circuitry, wherein the first and third transistors are connected to the first node and the second and fourth transistors are connected to the second node; wherein the differential impedance matching circuitry comprises a third node arranged between the first and second nodes and arranged to selectively receive a first or a second voltage.

Thanks to the invention, the voltage at a tap in the differential impedance matching circuitry may be selectively controlled. This implies that a potential at the first and the second nodes may be controlled and may be different for a transmit mode and a receive mode. Thus, the PA output stage and the LNA input stage may be designed in relation to such different potentials allowing a flexibility, e.g. in a choice of using n-type or p-type metal-oxide-semiconductor transistors, in design of the LNA input stage.

According to an embodiment, the first voltage is set such that a drain to source voltage is zero for the third transistor and the fourth transistor when the third node receives the first voltage.

The voltage received at the third node may thus be controlled so that the third and the fourth transistors have a drain to source voltage that is zero in a transmit mode of the integrated circuit. Thus, the LNA input stage can be controlled to be turned off by a drain to source voltage being zero, which provides a very good isolation of the receiving circuitry from the transmitter circuitry.

According to an embodiment, a source terminal of the third transistor is connected to the first node and a drain terminal of the third transistor is connected to the first voltage. Similarly, a source terminal of the fourth transistor is connected to the second node and a drain terminal of the fourth transistor is connected to the first voltage. Thus, the drain terminals of the third and fourth transistors may always be connected to the first voltage. This implies that when the third node receives the first voltage, the drain and source terminals of the third and the fourth transistors will be connected to the same voltage, whereby a drain to source voltage will be zero.

In other words, according to an embodiment, a bias voltage of the LNA input stage matches the first voltage, which implies that the drain to source voltage will be zero.

According to an embodiment, a drain terminal of the first transistor is connected to the first node and a source terminal of the first transistor is connected to the second voltage. Similarly, a drain terminal of the second transistor is connected to the second node and a source terminal of the second transistor is connected to the second voltage. Thus, the drain terminals of the first and second transistors may always be connected to the first voltage. This implies that when the third node receives the second voltage, the source and drain terminals of the first and the second transistors will be connected to the same voltage, whereby a drain to source voltage will be zero. Thus, the PA output stage can be controlled to be turned off by a drain to source voltage being zero, which provides a very good isolation of the transmitter circuitry from the receiving circuitry.

According to an embodiment, the second voltage is ground voltage. The third node may thus be arranged to receive a ground voltage of the integrated circuit in a receive mode of the integrated circuit. Further, the first voltage received by the third node may be a supply voltage of the integrated circuit. This implies that a maximum drain to source voltage of the first and second transistors may be provided in a transmit mode of the integrated circuit, as the drain to source voltage of the first and second transistors in the transmit mode will be a difference between the first and the second voltages.

The first voltage may be smaller than the second voltage. This implies that the voltage at the source terminals of the third and fourth transistors will be larger than the voltage at the drain terminals in the receive mode of the integrated circuit. This implies that a p-type metal-oxide-semiconductor transistor may need to be used for the third and the fourth transistors.

According to an embodiment, the third and fourth transistors are n-type metal-oxide-semiconductor (NMOS) transistors. As explained above, the use of NMOS transistors may be enabled thanks to the third node of the differential matching circuitry being arranged to selectively receive a first voltage and a second voltage. This allows using a larger voltage at the drain terminals of the third and fourth transistors than at the source terminals such that NMOS transistors may be used.

Use of NMOS transistors may be highly advantageous in comparison to using PMOS transistors. NMOS transistors may have a better performance than PMOS transistors, e.g. the NMOS transistors may be much faster than PMOS transistors.

Further, NMOS transistors can be smaller for the same complexity, which also means that NMOS transistors are typically characterized before PMOS transistors when going to smaller technology node. Thus, by using NMOS transistors, the integrated circuit may be able to be produced in a smaller scale at an early stage of technology development.

Also, the LNA may have better gain and noise figure thanks to use of NMOS transistors. Thus, the use of NMOS transistors may ensure a better performance of the LNA.

Thus, since the integrated circuit enables using NMOS transistors in the LNA output stage, the integrated circuit may be provided with a number of advantages.

According to an embodiment, the third and fourth transistors are common-gate transistors. For such amplifying transistors, an input signal is provided at the source terminal and an output signal is provided at the drain terminal. This implies that the drain terminals may have a potential defined by a bias voltage of the LNA input stage and the source terminals may have a potential based on the voltage received by the third node. Thus, the integrated circuit may be easily set up such that a drain-to-source voltage of the third and fourth transistors is zero in a transmit mode.

According to an embodiment, the first and second transistors are common-source transistors. For such amplifying transistors, an input signal is provided at the gate terminal and an output signal is provided at the source terminal. This implies that the drain terminals may have a ground voltage potential and the source terminals may have a potential based on the voltage received by the third node. Thus, the integrated circuit may be easily set up such that a drain-to-source voltage of the first and second transistors is zero in a transmit mode by the third node receiving a ground voltage.

According to an embodiment, the differential impedance matching circuitry comprises a transformer or a balun. A transformer or balun may facilitate impedance matching of the transmitter circuitry and the receiver circuitry, respectively, to the antenna.

According to an embodiment, the transceiver is operated in a time-division duplex (TDD) protocol. This implies that the integrated circuit may be switched between acting in a transmit mode and acting in a receive mode. The integrated circuit provides selectively turning off the transmitter circuitry or the receiver circuitry in the receive mode and the transmit mode, respectively, and is therefore particularly suitable for use in a TDD protocol.

According to a second aspect, there is provided a method for switching between transmit mode and receive mode in an integrated circuit, said method comprising: switching to operate in transmit mode by: setting a first voltage of a third node of a differential impedance matching circuitry arranged between a first node on one side of the differential impedance matching circuitry and a second node on an opposite side from the first node of the differential impedance matching circuitry to turn off a low noise amplifier input stage, wherein the low noise amplifier input stage comprises a third transistor and a fourth transistor, wherein the third transistor is connected to the first node and the fourth transistor is connected to the second node; and turning on a power amplifier output stage, wherein the power amplifier output stage comprises a first transistor and a second transistor, wherein the first transistor is connected to the first node and the second transistor is connected to the second node, wherein said turning on of the power amplifier output stage comprises operating on gates of the first and second transistors, and wherein the differential impedance matching circuitry is arranged to be connected to an antenna; and switching to operate in receive mode by: turning off the power amplifier output stage by operating on gates of the first and second transistors; and setting a second voltage of the third node to turn on the low noise amplifier input stage.

Thanks to the switching of the voltage at the third node of the differential impedance matching circuitry, the PA output stage and the LNA input stage may be adapted to the respective voltages at the third node of the differential impedance matching circuitry such that a drain to source voltage of the transistors of the PA output stage and LNA input stage, respectively, may be zero when turned off. This implies that the method may provide very good isolation of the PA output stage from the LNA input stage.

When switching to the transmit mode, the voltage of the third node may first be set to a first voltage. This implies that the third and fourth transistors of the LNA input stage may be turned off by the first voltage matching a bias voltage of the LNA input stage such that a drain to source voltage of the third and fourth transistors become zero. The LNA input stage is thus isolated from the transmitter circuitry before the PA output stage is turned on.

Similarly, when switching to receive mode, the PA output stage may first be turned off. Then, the voltage of the third node may be set to the second voltage, which turns on the LNA input stage. Thus, since the PA output stage is turned off before the LNA input stage is turned on, the LNA input stage may not be exposed by the output power of the transmitter circuitry.

According to an embodiment, the second voltage is ground voltage. With a ground voltage bias of the PA output stage, this implies that drain to source voltage of the first and second transistors become zero in the receive mode. This further acts to isolate the transmitter circuitry from the receiver circuitry.

### Brief Description of Drawings

The above, as well as additional objects, features and advantages of the present inventive concept, will be better understood through the following illustrative and non-limiting detailed description of preferred embodiments of the present inventive concept, with reference to the appended drawings. In the drawings like reference numerals will be used for like elements unless stated otherwise.
Fig. 1 is a schematic view of an integrated circuit according to an embodiment.
Fig. 2 is a schematic view of the integrated circuit of Fig. 1 in a transmit mode.
Fig. 3 is a schematic view of the integrated circuit of Fig. 1 in a receive mode.
Fig. 4 is a flowchart of a method according to an embodiment.

### Detailed Description

Detailed embodiments of the present invention will now be described with reference to the drawings.

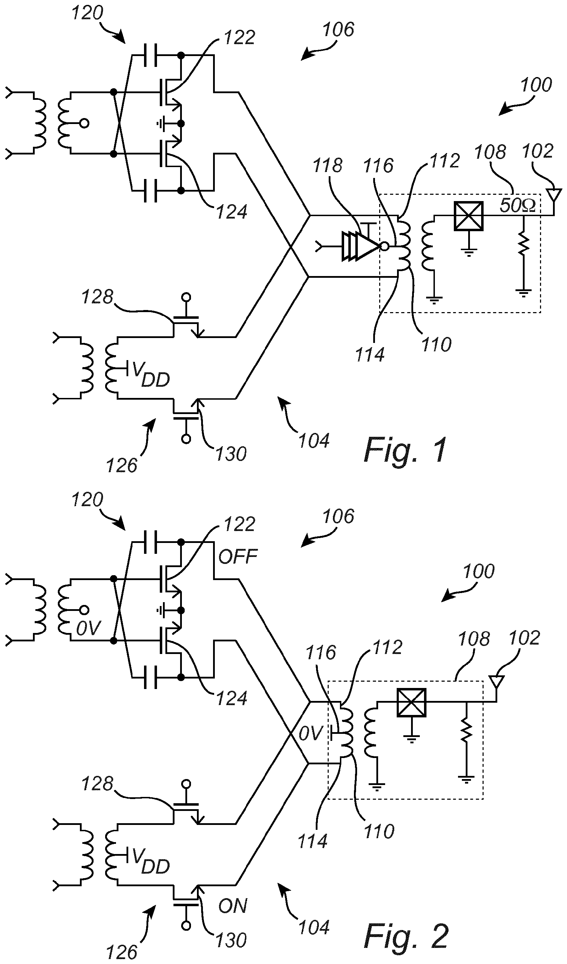

Referring now to Fig. 1, an integrated circuit 100 for a transceiver will be described. The transceiver comprises an antenna 102 and is arranged to receive and transmit signals through the antenna 102.

The transceiver may be arranged to operate to alternately receive signals and transmit signals. In particular, the transceiver may be arranged to operate in a time-division duplex (TDD) protocol. A recevier circuitry 104 and a transmitter circuitry 106 may thus be alternately connected to the antenna 102.

The integrated circuit 100 comprises a differential impedance matching circuitry 108. The differential impedance matching circuitry 108 is connected to the antenna 102 and provides a common impedance matching of the transmitter circuitry to the antenna 102 and the receiver circuitry to the antenna 102.

The differential impedance matching circuitry 108 may comprise a transformer 110 or balun. The transformer 110 or balun may facilitate impedance matching.

The differential impedance matching circuitry 108 may have a first node 112 on a first side of a primary winding of the transformer 110 or balun. Further, the differential impedance matching circuitry 108 may have a second node 114 on an opposite side of the primary winding of the transformer 110 or balun. The receiver circuitry 104 and the transmitter circuitry 106 may be arranged to be connected to the differential impedance matching circuitry 108 through the first noed 112 and the second node 114.

The differential impedance matching circuitry 108 may further comprise a third node 116 arranged to selectively receive a first voltage or a second voltage. The third node 116 may be arranged as a tap in the primary winding provided by an inductor of the tansformer 110. The tap may be a center tap arranged half-way between the first node 112 and the second node 114, but may alternatively be arranged closer to one of the nodes.

A switch 118 may be connected to the third node 116 for selectively connecting the first voltage or the second voltage to the third node 116. The switch 118 may be provided in many different ways. For instance, an inverter may be provided to switch between the first voltage and the second voltage being received at the third node 116. According to an alternative, a low-dropout regulator may be used, which may be advantageous in that no switching noise is associated with the changing between the third node 116 receiving the first voltage or the second voltage.

Thus, the third node 116 may selectively receive a first DC voltage or a second DC voltage. As the primary winding of the transformer 110 or balun is inductive, both the differential terminals at the first node 112 and the second node 114 will have the same voltage as the third node 116 in DC.

The differential matching circuitry 110 may thus be switched between providing different potentials at the first and second nodes 110, 112, which may fit the receiver circuitry 104 and the transmitter circuitry 106, respectively.

The transmitter circuitry 106 may be arranged to generate a signal to be transmitted by the antenna 102. The transmitter circuitry 106 may be arranged to amplify the signal to be transmitted and may comprise a power amplifier (PA) output stage 120, which may be connected to the differential impedance matching circuitry 110.

The PA output stage 120 may comprise a first transistor 122 and a second transistor 124 acting to amplify a signal to be transmitted. The first transistor 122 may be connected to the first node 112 and the second transistor 124 may be connected to the second node 114.

A terminal of the first transistor 122 and a terminal of the second transistor 124 may further be connected to the second voltage providing a bias voltage to the PA output stage 120, which may match the voltage that may be selectively provided on the first node 112 and the second node 114.

The first transistor 122 and the second transistor 124 may be common-source transistors, wherein the source terminals of the first transistor 122 and the second transistor 124 may be connected to the second voltage. The drain terminal of the first transistor 122 may be connected to the first node 112 and the drain terminal of the second transistor 124 may be connected to the second node 114. This implies that when the integrated circuit 100 is in a receive mode, the second voltage may be provided on both source terminals and drain terminals of the first transistor 122 and the second transistor 124. Thus, the drain to source voltage of the first transistor 122 and the second transistor 124 is zero, ensuring that the PA output stage 120 is turned off.

The signal to be output by the PA output stage 120 may be provided on gate terminals of the first transistor 122 and the second transistor 124 to be output to the differential impedance matching circuitry 110.

The PA output stage 120 may be connected to earlier stages of the transmitter circuitry 106 for generating the signal. These stages are not further described here and may be configured in various different ways as will be appreciated by those skilled in the art.

The receiver circuitry 104 may be arranged to receive a low-power signal from the antenna 102 and amplify the signal. The receiver circuitry 104 may thus comprise a low noise amplifier (LNA) input stage 126, which may be connected to the differential impedance matching circuitry 110, so as to perform first amplification of the signal. The LNA input stage 126 may thus be arranged to receive signals from the antenna 102 via the differential impedance matching circuitry 110 and may be connected to the first node 112 and the second node 114.

The LNA input stage 126 may comprise a third transistor 128 and a fourth transistor 130 acting to amplify a signal received from the antenna 102. The third transistor 128 may be connected to the first node 112 and the fourth transistor 124 may be connected to the second node 114.

A terminal of the third transistor 128 and a terminal of the second transistor 130 may further be connected to the first voltage providing a bias voltage to the LNA input stage 126, which may match the voltage that may be selectively provided on the first node 112 and the second node 114.

The third transistor 128 and the fourth transistor 130 may be common-gate transistors, wherein the drain terminals of the third transistor 128 and the fourth transistor 130 may be connected to the first voltage. The source terminal of the third transistor 128 may be connected to the first node 112 and the source terminal of the second transistor 124 may be connected to the second node 114. This implies that when the integrated circuit 100 is in a transmit mode, the first voltage may be provided on both source terminals and drain terminals of the third transistor 128 and the fourth transistor 130. Thus, the drain to source voltage of the third transistor 128 and the fourth transistor 130 is zero, ensuring that the LNA input stage 126 is turned off.

The drain terminals of the third transistor 128 and the fourth transistor 130 may be connected to a transformer for transferring a signal from the LNA input stage 126 to a further stage of the receiver circuitry 104. Thus, the first voltage may be provided on a tap of the transformer, such that differential terminals of the transformer connected to the drain terminals of the first transistor 128 and the second transistor 130 will also be provided with the first voltage in DC.

The signal to be amplified by the LNA input stage 126 may be provided on the source terminals of the third transistor 128 and the fourth transistor 130 by the differential impedance matching circuitry 110.

The LNA input stage 126 may be connected to further stages of the receiver circuitry 104 for receiving the signal. These stages are not further described here and may be configured in various different ways as will be appreciated by those skilled in the art.

The first voltage and the second voltage may be a supply voltage of the integrated circuit 100 and a ground voltage of the integrated circuit 100 such that the first and the second voltages may be readily available in the integrated circuit 100 and that the same voltages may be easily provided to different terminals within the integrated circuit 100.

When either the receiver circuitry 104 or the transmitter circuitry 106 is active, the transistors of the active circuitry will have a drain to source voltage that equals the difference between the first voltage and the second voltage. Thus, if the supply voltage and the ground voltage are provided as the first and second voltages a maximum drain to source voltage is provided for the transistors of the active circuitry.

The first voltage may be ground voltage and the second voltage may be supply voltage. This implies that the voltage at source terminals of the transistors 122, 124, 128, 130 will be larger than the voltage at the drain terminals of the transistors for the active circuitry. This implies that p-type metal-oxide-semiconductor (PMOS) transistors will be used.

Alternatively, the second voltage may be ground voltage and the first voltage may be supply voltage. This implies that the voltage at the drain terminals of the transistors 122, 124, 128, 130 will be larger than the voltage at the source terminals of the transistors for the active circuitry. This implies that n-type metal-oxide-semiconductor (NMOS) transistors will be used.

Use of NMOS transistors may be advantageous for a number of reasons. NMOS transistors may have be faster than PMOS transistors. Further, NMOS transistors can be smaller for the same complexity. Also, the LNA may have better gain and noise figure thanks to use of NMOS transistors.

Referring now to Fig. 2, a setting of the integrated circuit 100 in a transmit mode of the transceiver will be described.

According to the embodiment shown in Fig. 2, the third node 116 is arranged to receive a supply voltage in the transmit mode. As the drain terminals of the third and fourth transistors 128, 130 are also connected to the suppy voltage, a drain to source voltage of the third and fourth transistors 128, 130 is zero in the transmit mode. This implies that the third and fourth transistors 128, 130 are turned off and that the receiver circuitry 104 is very well isolated from the transmitter circuitry 106.

The first and second transistors 122, 124 of the PA output stage 120 have a source terminal connected to ground voltage and a drain terminal connected to the supply voltage. Thus, in the transmit mode, a maximum drain to source voltage is provided for the first and the second transistors 122, 124.

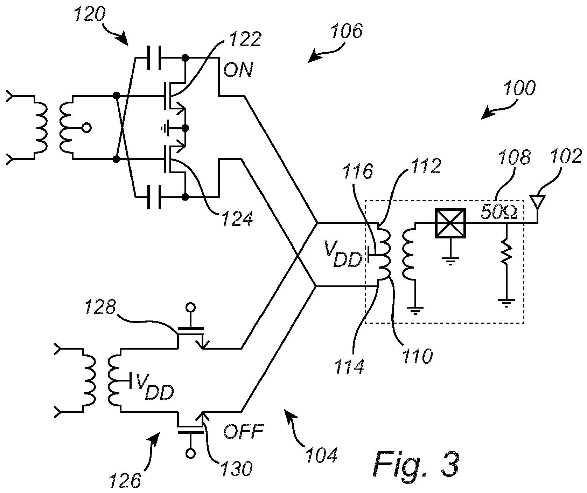

Referring now to Fig. 3, a setting of the integrated circuit 100 in a receive mode of the transceiver will be described.

According to the embodiment shown in Fig. 3, the third node 116 is arranged to receive a ground voltage in the receive mode. As the drain terminals of the first and second transistors 122, 124 are also connected to the ground voltage, a drain to source voltage of the first and second transistors 122, 124 is zero in the receive mode. This implies that the first and second transistors 122, 124 are turned off and that the transmitter circuitry 106 is very well isolated from the receiver circuitry 104.

The third and fourth transistors 128, 130 of the LNA input stage 126 have a source terminal connected to ground voltage and a drain terminal connected to the supply voltage. Thus, in the receive mode, a maximum drain to source voltage is provided for the third and the fourth transistors 128, 130.

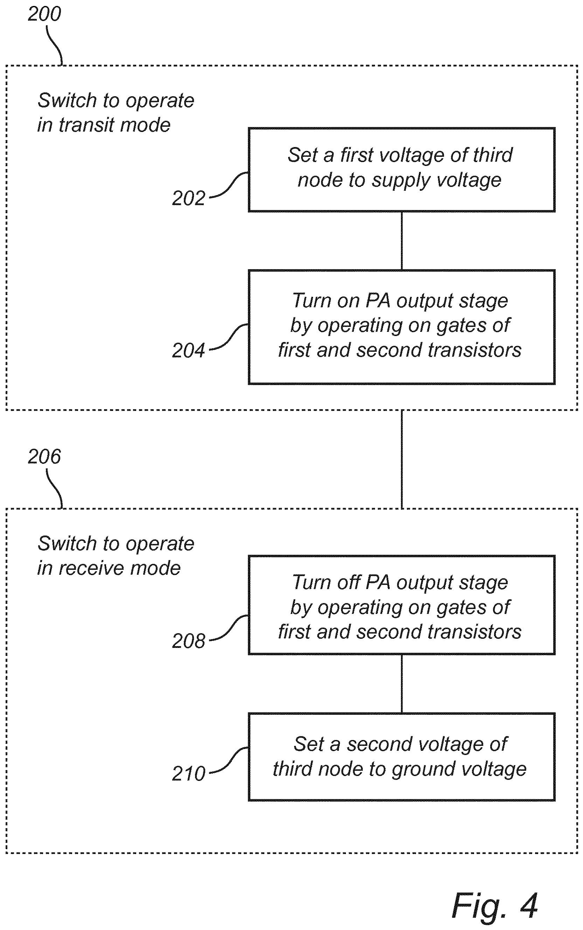

Referring now to Fig. 4, a method for switching between transmit mode and receive mode will be discussed.

The method may comprise switching 200 to operate in transmit mode. The switching to operate in transmit mode may comprise setting 202 a first voltage of the third node 116 to supply voltage in order to turn off the LNA input stage 126. The drain to source voltage of the third transistor 128 and the fourth transistor 130 will thus be zero and the LNA input stage 126 may in this manner be turned off. The LNA input stage 126 is thus isolated from the transmitter circuitry 106 before the PA output stage 120 is turned on.

The switching to operate in transmit mode may further comprise turning on 204 the PA output stage 120 by operating on gates of the first and second transistors 122, 124.

The method may further comprise switching 206 to operate in receive mode. The switching to operate in receive mode may comprise turning off 208 the PA output stage 120 by operating on gates of the first and second transistor 122, 124. Thus, the PA output stage 120 is turned off so that the LNA input stage 126 is not to be exposed by the output power of the transmitter circuitry 106.

The switching to operate in receive mode further comprises setting 210 a second voltage of the third node 116 to ground voltage in order turn on the LNA input stage 126. Also, by the setting of the second voltage of the third node 116 to ground voltage, a drain to source voltage of the first and second transistors 122, 124 of the PA output stage 120 is zero, ensuring that the PA output stage 120 is well isolated from the receiver circuitry 104.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. An integrated circuit for a transceiver, said integrated circuit comprising:
a power amplifier, PA, output stage (120) comprising a first transistor (122) and a second transistor (124);
a low noise amplifier, LNA, input stage (126) comprising a third transistor (128) and a fourth transistor (130);
a differential impedance matching circuitry (108) configured to be connected to an antenna (102), wherein the differential impedance matching circuitry (108) comprises a first node (112) on one side of the differential impedance matching circuitry (108) and a second node (114) on an opposite side of the differential impedance matching circuitry (108),
wherein the first and third transistors (122; 128) are connected to the first node (112) and the second and fourth transistors (124; 130) are connected to the second node (114);
wherein the differential impedance matching circuitry (108) comprises a third node (116) arranged between the first and second nodes (112; 114) and arranged to selectively receive a first or a second voltage.

2. The integrated circuit according to claim 1, wherein the first voltage is set such that a drain to source voltage is zero for the third transistor (128) and the fourth transistor (130) when the third node (116) receives the first voltage.

3. The integrated circuit according to claim 2, wherein a bias voltage of the LNA input stage (126) matches the first voltage.

4. The integrated circuit according to any one of the preceding claims, wherein the second voltage is ground voltage.

5. The integrated circuit according to any one of the preceding claims, wherein the third and fourth transistors (128; 130) are n-type metal-oxide-semiconductor transistors.

6. The integrated circuit according to any one of the preceding claims, wherein the third and fourth transistors (128; 130) are common gate transistors.

7. The integrated circuit according to any one of the preceding claims, wherein the first and second transistors (122; 124) are common source transistors.

8. The integrated circuit according to any one of the preceding claims, wherein the differential impedance matching circuitry (108) comprises a transformer (110) or a balun.

9. The integrated circuit according to any one of the preceding claims, wherein the transceiver is operated in a time-division duplex protocol.

10. A method for switching between transmit mode and receive mode in an integrated circuit (100), said method comprising:
switching (200) to operate in transmit mode by:
setting (202) a first voltage of a third node (116) of a differential impedance matching circuitry (108) arranged between a first node (112) on one side of the differential impedance matching circuitry (108) and a second node (114) on an opposite side from the first node (112) of the differential impedance matching circuitry (108) to turn off a low noise amplifier input stage (126), wherein the low noise amplifier input stage (126) comprises a third transistor (128) and a fourth transistor (130), wherein the third transistor (128) is connected to the first node (112) and the fourth transistor (130) is connected to the second node (114); and
turning on (204) a power amplifier output stage (120), wherein the power amplifier output stage (120) comprises a first transistor (122) and a second transistor (124), wherein the first transistor (122) is connected to the first node (112) and the second transistor (124) is connected to the second node (114), wherein said turning on of the power amplifier output stage (120) comprises operating on gates of the first and second transistors (122; 124), and wherein the differential impedance matching circuitry (108) is arranged to be connected to an antenna (102); and
switching (206) to operate in receive mode by:
turning off (208) the power amplifier output stage (120) by operating on gates of the first and second transistors (122; 124); and
setting (210) a second voltage of the third node (116) to turn on the low noise amplifier input stage (126).

11. The method according to claim 10, wherein the second voltage is ground voltage.
